(19) Europäisches Patentamt
European Patent Office
Office européen des brevets

(11) **EP 4 503 902 A1**

(12) **EUROPEAN PATENT APPLICATION**
published in accordance with Art. 153(4) EPC

(43) Date of publication:
**05.02.2025 Bulletin 2025/06**

(21) Application number: **23807657.4**

(22) Date of filing: **17.05.2023**

(51) International Patent Classification (IPC):
*H10N 30/87* (2023.01)     *G06F 3/041* (2006.01)
*G06F 3/047* (2006.01)     *H01B 5/14* (2006.01)
*H10N 30/045* (2023.01)     *H10N 30/06* (2023.01)
*H10N 30/20* (2023.01)     *H10N 30/30* (2023.01)
*H10N 30/857* (2023.01)

(52) Cooperative Patent Classification (CPC):
**H10N 30/857; G06F 3/041; G06F 3/047;
H01B 5/14; H10N 30/06; H10N 30/877;
H10N 30/878; H10N 30/883**

(86) International application number:
**PCT/JP2023/018367**

(87) International publication number:
**WO 2023/224056 (23.11.2023 Gazette 2023/47)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **18.05.2022 JP 2022081448**

(71) Applicant: **Kureha Corporation**
**Chuo-ku**
**Tokyo 103-8552 (JP)**

(72) Inventor: **IMAJI Makoto**
**Tokyo 103-8552 (JP)**

(74) Representative: **Hoefer & Partner Patentanwälte
mbB**
**Pilgersheimer Straße 20**
**81543 München (DE)**

(54) **CONDUCTIVE PIEZOELECTRIC FILM, DEVICE, AND METHOD FOR PRODUCING CONDUCTIVE PIEZOELECTRIC FILM**

(57) Provided is a conductive piezoelectric film having a suppressed variation in transparency. The conductive piezoelectric film includes a piezoelectric film and a conductive layer laminated on one surface of the piezoelectric film and has a total light transmittance of 80% or more, and a standard deviation of the total light transmittance of 1.4% or less. The conductive layer contains at least one selected from the group consisting of a metal nanowire, a conductive polymer, a carbon nanotube, and graphene.

FIG. 1

EP 4 503 902 A1

**Description**

## TECHNICAL FIELD

The present invention relates to a conductive piezoelectric film, a device including a conductive piezoelectric film, and a method for producing a conductive piezoelectric film.

## BACKGROUND ART

Touch panels are widely used as devices with which information can be input by directly touching an image display unit. A representative type of touch panel is a capacitive touch panel which utilizes a change in current-carrying capacity between a transparent electrode and a finger (Patent Document 1).

A transparent conductive film is used in a position detection sensor utilized in a touch panel. For example, low resistance and high transmittance are achieved by forming an indium tin oxide (ITO) film on a PET film by dry coating such as sputtering and then increasing the crystallinity of ITO by a heat treatment (at or around 150°C).

Recently, technology for simultaneously detecting a position and pressure when an operation surface is touched by a finger or the like has been attracting rising attention, and a method of combining a pressure detection sensor, which is composed of a piezoelectric sensor, with a position detection sensor has been proposed. However, a piezoelectric film used in a piezoelectric sensor, such as a PET film, deteriorates in resistance and undergoes discoloration when the film is subjected to a heat treatment at a high temperature. Thus, it is difficult to use, in a touch panel, a conductive piezoelectric film on which an ITO film is formed by dry coating such as sputtering.

## CITATION LIST

### PATENT DOCUMENT

Patent Document 1: JP H05-324203 A

## SUMMARY OF INVENTION

### TECHNICAL PROBLEM

The present inventor has studied a wet coating method in which a solution containing a conductive substance such as a metal nanowire or a conductive polymer is applied as a conductive layer forming method that does not require a heat treatment at a high temperature. However, it has been found that, when a conductive layer is formed by applying a wet coating method to a piezoelectric film, variation in performance, in particular, variation in transparency occurs.

The present invention has been made in view of the above-described issues, and an object thereof is to provide a conductive piezoelectric film having a suppressed variation in transparency, a device including a conductive piezoelectric film, and a method for producing a conductive piezoelectric film.

### SOLUTION TO PROBLEM

The present inventor has found that the above-described issues are solved by a conductive piezoelectric film which includes a conductive layer containing a metal nanowire or the like and in which a total light transmittance and a standard deviation of the total light transmittance satisfy specific ranges, and has completed the present invention. Specifically, the present invention relates to the following.

The present invention relates to a conductive piezoelectric film including a piezoelectric film and a conductive layer laminated on one surface of the piezoelectric film. The conductive piezoelectric film has a total light transmittance of 80% or more and a standard deviation of the total light transmittance of 1.4% or less, and the conductive layer contains at least one selected from the group consisting of a metal nanowire, a conductive polymer, a carbon nanotube, and graphene.

A surface waviness Wa of the piezoelectric film at an interface with the conductive layer is preferably 30 $\mu$m or less.

In the conductive piezoelectric film, an absolute value of a thermal shrinkage when the film is heat treated at 80°C for 30 minutes is preferably at most less than 1.0%.

An adhesiveness of the conductive layer as evaluated based on ASTM D3359 is preferably 4B or more.

The metal nanowire is preferably a silver nanowire.

The piezoelectric film preferably contains a fluorine-based resin.

The present invention also relates to a device including the conductive piezoelectric film.

Furthermore, the present invention relates to a method for producing a conductive piezoelectric film, the method including a step of forming a conductive layer having a total light transmittance of 80% or more by applying a solution containing a conductive substance containing at least one selected from the group consisting of a metal nanowire, a conductive polymer, a carbon nanotube, and graphene to a surface of a piezoelectric film on which a protective film is laminated, the surface being opposite to the protective film.

A water contact angle of the surface to be applied with the solution in the step is preferably 70° or less. A modulus of elasticity of the protective film is preferably 1.0 GPa or more.

**ADVANTAGEOUS EFFECTS OF INVENTION**

The present invention makes it possible to provide a conductive piezoelectric film having a suppressed variation in transparency, a device including a conductive piezoelectric film, and a method for producing a conductive piezoelectric film.

**BRIEF DESCRIPTION OF THE DRAWINGS**

FIG. 1 is a cross-sectional view schematically illustrating a conductive piezoelectric film 1 which is an embodiment of a conductive piezoelectric film according to the present invention.
FIG. 2 is a cross-sectional view schematically illustrating a conductive piezoelectric film 2 which is another embodiment of the conductive piezoelectric film according to the present invention.

**DESCRIPTION OF EMBODIMENTS**

Hereinafter, embodiments of the present invention (hereinafter referred to as "the present embodiment") will be described in detail with reference to the drawings, but the present invention is not limited to these embodiments, and various modifications can be made without departing from the gist of the present invention.

Conductive Piezoelectric Film

A conductive piezoelectric film according to an embodiment of the present invention includes: a piezoelectric film; and a conductive layer laminated on one surface of the piezoelectric film, and the conductive piezoelectric film has a total light transmittance of 80% or more and a standard deviation of the total light transmittance of 1.4% or less, and the conductive layer contains at least one selected from the group consisting of a metal nanowire, a conductive polymer, a carbon nanotube, and graphene. In the present specification, "laminate" means that each layer is laminated in order and another layer may be laminated between the layers.

Properties of Conductive Piezoelectric Film

The conductive piezoelectric film has a total light transmittance of 80% or more, and a standard deviation of the total light transmittance of 1.4% or less.

A higher total light transmittance of the conductive piezoelectric film provides higher transparency, and thus is preferred. The total light transmittance of the film is more preferably 84% or more, still more preferably 86% or more, and particularly preferably 90% or more. The upper limit of the total light transmittance is not particularly limited.

A smaller standard deviation of the total light transmittance of the conductive piezoelectric film provides a smaller variation in transparency, and thus is preferred. The standard deviation of the total light transmittance of the film is preferably 1.4% or less, more preferably 1.1% or less, still more preferably 0.8% or less, and particularly preferably 0.5% or less. The lower limit of the standard deviation of the total light transmittance is not particularly limited.

In the present specification, the total light transmittance of the conductive piezoelectric film is a value as measured in conformity with JIS K 7361-1, and specifically can be measured by a method which will be described in Examples below. The standard deviation of the total light transmittance is a value calculated from the measured total light transmittance value.

The standard deviation of the total light transmittance can be reduced by, for example, laminating a protective film on a surface of the piezoelectric film opposite to a surface applied with a solution containing a conductive substance before the solution is applied to the piezoelectric film. The piezoelectric film has lower surface smoothness than that of a film made of PET or the like, and it is considered that variation in transparency occurs when the solution is applied to the surface of such a piezoelectric film. Therefore, it is considered that the smoothness of the piezoelectric film is improved by laminating the protective film. The standard deviation of the total light transmittance can be reduced also by a method in which, before application of a solution containing a conductive substance to a surface of a piezoelectric film, the surface of the piezoelectric film to be applied with the solution is subjected to a surface modification treatment (a corona treatment, a plasma treatment, a flame treatment, an ultraviolet irradiation treatment, or the like) or a transparent coating layer is formed on the surface of the piezoelectric film to be applied with the solution, whereby the surface to be applied with the solution has a water contact angle of 70° or less. It is considered that the variation in transparency occurs, also because the piezoelectric film has low wettability with respect to the above-described aqueous solution and the above-described solution is repelled and applied unevenly. Therefore, it is considered that the uneven application of the solution can be eliminated by setting the water contact angle of the surface to be applied with the solution to 70° or less.

The surface waviness Wa of the piezoelectric film at the interface with the conductive layer is preferably 30 μm or less, and more preferably 25 μm or less. The lower limit of the surface waviness Wa is not particularly limited. When the surface waviness Wa is 30 μm or less, the smoothness of the surface of the piezoelectric film is good, a coating film of the conductive layer is likely to be more uniform, and the variation in transparency is likely to be suppressed. In the present specification, the surface waviness Wa is an arithmetic average height in a reference length of a waviness curve as a contour curve. The waviness curve represents larger scale unevennesses (i.e., waviness) rather than fine unevennesses represented by the roughness curve. Specifically, the surface waviness Wa can be measured by a method which will be described in Examples below.

In the conductive piezoelectric film, the absolute value of the thermal shrinkage when the film is heat treated at 80°C for 30 minutes is preferably less than 1.0%, and more preferably less than 0.5%, at most (in any direction). The lower limit of the absolute value of the thermal shrinkage is not particularly limited. An absolute value of the thermal shrinkage falling within the above-described range means a low absolute value of the thermal shrinkage of the piezoelectric film to be used. Since the piezoelectric film is less likely to shrink in a drying process of the coating film, a more uniform conductive layer is easily obtained, and the variation in transparency is easily suppressed.

In the present specification, the thermal shrinkage can be specifically measured by a method which will be described in Examples below.

The thermal shrinkage of the conductive piezoelectric film can be reduced by subjecting the piezoelectric film subjected to a polarization treatment to a heat treatment, for example, at 130°C for 1 minute.

In the conductive piezoelectric film, the adhesiveness of the conductive layer as evaluated based on ASTM D3359 is preferably 4B or more.

In the present specification, the adhesiveness of the conductive layer means adhesiveness between the conductive layer and a layer adjacent to the conductive layer on the piezoelectric film side. For example, when the piezoelectric film and the conductive layer are adjacent to each other, it means adhesiveness between the piezoelectric film and the conductive layer. When a transparent coating layer is disposed between the piezoelectric film and the conductive layer, it means adhesiveness between the transparent coating layer and the conductive layer. The adhesiveness of the conductive layer can be measured by a method which will be described in Examples below.

A haze value of the conductive piezoelectric film is preferably 3.0% or less, more preferably 2.5% or less, still more preferably 2.0% or less, and particularly preferably 1.5% or less. The lower limit of the haze value is not particularly limited. In the present specification, the haze value of the conductive piezoelectric film is a value as measured in conformity with JIS K 7136, and specifically can be measured by a method which will be described in Examples below.

A sheet resistance of the conductive piezoelectric film is preferably 1000 Ω/sq or less, more preferably 600 Ω/sq or less, still more preferably 400 Ω/sq or less, and particularly preferably 200 Ω/sq or less. The lower limit of the sheet resistance is not particularly limited, but is preferably 10 Ω/sq or more, more preferably 20 Ω/sq or more, and particularly preferably 40 Ω/sq or more, from the viewpoint of transparency. In addition, the lower limit of the sheet resistance is not particularly limited, but a combination of numerical ranges is preferably 10 Ω/sq or more and 1000 Ω/sq or less, more preferably 10 Ω/sq or more and 600 Ω/sq or less, still more preferably 20 Ω/sq or more and 400 Ω/sq or less, and particularly preferably 40 Ω/sq or more and 200 Ω/sq or less. In the present specification, the sheet resistance of the conductive piezoelectric film is a value as measured in conformity with JIS K 7194, and specifically can be measured by a method which will be described in Examples below.

Furthermore, the conductive piezoelectric film preferably has a thickness of, for example, 25 μm or more and 120 μm or less. When the thickness of the piezoelectric film is 25 μm or more, an amount of charge to be generated by a piezoelectric effect is further increased, and higher piezoelectricity is easily obtained. The thickness of the piezoelectric film is more preferably 30 μm or more and still more preferably 35 μm or more. When the thickness of the piezoelectric film is 120 μm or less, the transparency of the piezoelectric film is less likely to be impaired. The thickness of the piezoelectric film is more preferably 100 μm or less, and still more preferably 80 μm or less. From the same viewpoint, the thickness of the piezoelectric film is more preferably 35 μm or more and 80 μm or less. In the present specification, the thickness of the conductive piezoelectric film or each layer is obtained by randomly measuring thicknesses at 10 points from a cross-sectional photograph of the layer taken at 10000 to 100000 times using a scanning electron microscope (SEM), and calculating an arithmetic average value of the measured thicknesses at the 10 points.

Next, each layer of the conductive piezoelectric film will be described with reference to drawings.

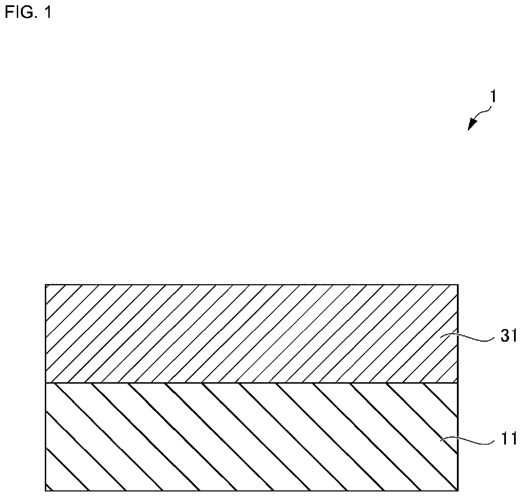

FIG. 1 is a cross-sectional view schematically illustrating a conductive piezoelectric film 1 which is an embodiment of the conductive piezoelectric film. **The** conductive piezoelectric film 1 includes a conductive layer 31 laminated on one surface of a piezoelectric film 11.

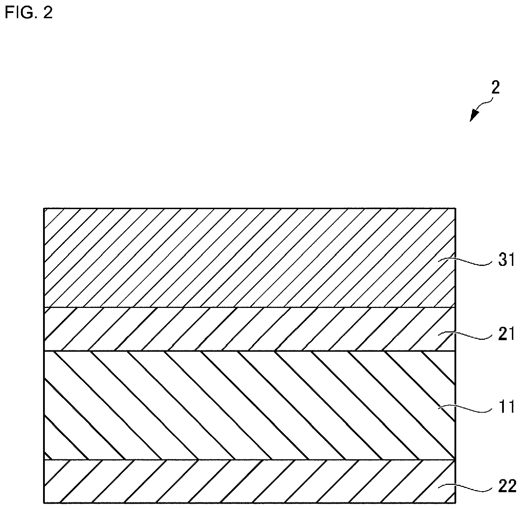

FIG. 2 is a cross-sectional view schematically illustrating a conductive piezoelectric film 2 which is another embodiment of the conductive piezoelectric film. A conductive piezoelectric film 2 is different from the conductive piezoelectric film 1 in that the conductive piezoelectric film 2 includes a pair of transparent coating layers (a first transparent coating layer 21 and a second transparent coating layer 22) which sandwich the piezoelectric film 11. Other configurations are the same as those of the conductive piezoelectric film 1.

Piezoelectric Film

The piezoelectric film 11 is a film (thin film) with piezoelectricity (a property of converting an applied force to a voltage or a property of converting an applied voltage to a force).

Examples of the material constituting the piezoelectric film 11 include a polarized polar polymer capable of exhibiting piezoelectricity by polarizing a molecular dipole by a polarization treatment generally called thermal poling treatment, and a stretched chiral polymer capable of exhibiting piezoelectricity by applying a stretching treatment to a chiral polymer. Examples of the polarized polar polymer include fluorine-based resins; vinylidene cyanide-based polymers; vinyl acetate-based polymers; odd-numbered nylons such as nylon 9 and nylon 11; and polyureas. Examples of the stretched chiral polymer include helical chiral polymers such as polylactic acid; polyhydroxycarboxylic acids such as polyhydroxybutyrate; and cellulose-based derivatives. One of these can be used individually, or two or more can be used in combination. Among these, a fluorine-based resin is preferred, and a homopolymer of vinylidene fluoride is more preferred, from the viewpoint of easily increasing a piezoelectric constant $d_{33}$ of the piezoelectric film and more easily obtaining the piezoelectric effect. The piezoelectric film preferably has a piezoelectric constant $d_{33}$ of 10 pC/N or more and 40 pC/N or less. When the piezoelectric constant $d_{33}$ of the piezoelectric film is 10 pC/N or more, the amount of charge to be generated by the piezoelectric effect is larger, and thus pressure sensitivity can be further enhanced. When the piezoelectric constant $d_{33}$ of the piezoelectric film is 40 pC/N or less, it is possible to further reduce a decrease in flatness of the surfaces of the piezoelectric film caused by, for example, the polarization treatment, and thus to further reduce the standard deviation of the total light transmittance. Furthermore, the piezoelectric constant $d_{33}$ of the piezoelectric film is more preferably 13 pC/N or more and 35 pC/N or less, and still more preferably 15 pC/N or more and 30 pC/N or less. In the present specification, the piezoelectric constant $d_{33}$ is a charge to be generated when clipping a sample at 0.2 N and applying a force of 0.15 N and 110 Hz, using a piezoelectric constant measuring device ("Piezometer System PM300", available from Piezotest Pte Ltd). The actual measurement value of the piezoelectric constant $d_{33}$ is a positive value or a negative value, depending on whether the front or back side of the film is measured. However, the absolute value is described in the present specification.

Examples of the fluorine-based resin include polyvinylidene fluoride (PVDF), vinylidene fluoride-based copolymers (e.g., vinylidene fluoride/trifluoroethylene copolymers, vinylidene fluoride/trifluoroethylene/chlorotrifluoroethylene copolymers, hexafluoropropylene/vinylidene fluoride copolymers, perfluorovinyl ether/vinylidene fluoride copolymers, tetrafluoroethylene/vinylidene fluoride copolymers, hexafluoropropylene oxide/vinylidene fluoride copolymers, hexafluoropropylene oxide/tetrafluoroethylene/vinylidene fluoride copolymers, and hexafluoropropylene/tetrafluoroethylene/vinylidene fluoride copolymers); tetrafluoroethylene-based polymers; and chlorotrifluoroethylene-based polymers. One of these can be used individually, or two or more can be used in combination. Among these, in terms of high piezoelectricity, weather resistance, heat resistance, and the like to be obtained, a polyvinylidene fluoride and/or a vinylidene fluoride-based copolymer is more preferred.

The piezoelectric constant $d_{33}$ of the piezoelectric film 11 can be adjusted mainly by the type of resin included in the piezoelectric film 11 and production conditions (conditions for the polarization treatment and the stretching treatment). For example, among fluorine-based resins, the piezoelectric constant $d_{33}$ of the piezoelectric film 11 is likely to be increased as the resin includes more structural units derived from vinylidene fluoride. In addition, the piezoelectric constant $d_{33}$ of the piezoelectric film is likely to be increased by strengthening the polarization treatment or the stretching treatment.

Furthermore, the piezoelectric film 11 preferably has a thickness of, for example, 25 $\mu$m or more and 120 $\mu$m or less. When the thickness of the piezoelectric film 11 is 25 $\mu$m or more, the amount of the charge to be generated by the piezoelectric effect is further increased, and higher piezoelectricity is easily obtained. The thickness of the piezoelectric film 11 is more preferably 30 $\mu$m or more and still more preferably 35 $\mu$m or more. When the thickness of the piezoelectric film 11 is 120 $\mu$m or less, the transparency of the piezoelectric film 11 is less likely to be impaired. The thickness of the piezoelectric film is more preferably 100 $\mu$m or less, and still more preferably 80 $\mu$m or less. From the same viewpoint, the thickness of the piezoelectric film is more preferably 35 $\mu$m or more and 80 $\mu$m or less.

Conductive Layer

The conductive layer 31 contains at least one selected from the group consisting of a metal nanowire, a conductive polymer, a carbon nanotube, and graphene. The conductive layer 31 includes these conductive substances, and thus can achieve both conductivity and transparency.

The metal nanowire refers to a conductive substance made of a metal, having a needle or thread shape, and having a nanometer-sized diameter. The metal nanowire may be linear or curved. Examples of the metal nanowire include silver nanowires, gold nanowires, copper nanowires, and nickel nanowires. One of these can be used individually, or two or more can be used in combination. Among these, a silver nanowire is preferred.

An average diameter, an average length, and an aspect ratio (average length/average diameter) of the metal nanowire are not particularly limited as long as good conductivity and transparency are obtained. For example, the average diameter is preferably 10 nm or more and 500 nm or less, and more preferably 10 nm or more and 100 nm or less. The average length is preferably 1 $\mu$m or more and 300 $\mu$m or less, and more preferably 1 $\mu$m or more and 100 $\mu$m or less. The aspect ratio (average length/average diameter) is preferably 10 or more and 10000 or less, and more preferably 100 or more and 5000 or less. The average diameter and the average length of the metal nanowire are values determined by measuring dimensions of arbitrarily selected 100 metal nanowires using a scanning electron microscope and calculating an arithmetic average value of the measured dimensions.

Known production methods can be used as the method for producing a metal nanowire. For example, a silver nanowire can be synthesized by reducing silver nitrate in the presence of polyvinylpyrrolidone using a Poly-ol method (see Chem. Mater., 2002, 14, 4736 to 4745). Similarly, a gold nanowire can be synthesized by reducing chlorauric acid hydrate in the presence of polyvinylpyrrolidone (see J. Am. Chem. Soc., 2007, 129, 1733 to 1742).

As the conductive polymer, for example, polythiophene, polypyrrole, polyaniline, polyacetylene, polyparaphenylene, polyparaphenylenevinylene, polyfluorene, or the like can be used. One of these may be used alone, or two or more may be used in combination. Among them, polythiophene is preferred, and a mixture (PEDOT/PSS) of poly 3,4-ethylenedioxythiophene and polystyrene sulfonic acid is more preferred.

The carbon nanotube is not particularly limited as long as good conductivity and transparency are obtained. For example, it may be a single-walled carbon nanotube or a multi-walled carbon nanotube such as a double-walled carbon nanotube. One of these can be used individually, or two or more can be used in combination.

The graphene is not particularly limited as long as good conductivity and transparency are obtained. For example, it may be single-layer graphene or multilayer graphene. Alternatively, it may be graphene oxide, graphene nanoribbon, or the like. One of these can be used individually, or two or more can be used in combination.

The conductive layer may contain a component other than these conductive substances in combination as long as the function thereof is not impaired. Examples of the other component include a surfactant, a surface conditioner, a corrosion inhibitor, a pH controlling agent, a binder resin, and a thickener. The conductive layer may contain a trace component or an inevitable component as long as the function thereof is not impaired.

The surfactant may be a compound having a surface active function. Examples of the surfactant include nonionic surfactants, anionic surfactants, cationic surfactants, and amphoteric surfactants. One of these can be used individually, or two or more can be used in combination.

The surface conditioner may be a surface conditioner capable of preventing surface defects such as bubbles, cissing, pinholes, and mottling of the coating film. Examples of the surface conditioner include acrylic compounds, vinyl-based compounds, silicone-based compounds, and fluorine-based compounds. One of these can be used individually, or two or more can be used in combination.

The corrosion inhibitor may be a compound capable of preventing metal from rusting, and specific examples thereof include imidazoles, benzimidazoles, benzotriazoles, tetrazoles, thiazoles, benzothiazoles, thiadiazoles, and thiazolines. One of these can be used individually, or two or more can be used in combination.

The pH controlling agent is a compound used for adjusting the pH of a solution containing a conductive substance, and specific examples thereof include sulfuric acid, acetic acid, sodium hydroxide, potassium hydroxide, ammonia, dimethylamine, ethanolamine, and dimethylethanolamine. One of these can be used individually, or two or more can be used in combination.

The binder resin to be used is not particularly limited as long as it is a resin dissolvable or dispersible in a solvent used in the solution containing a conductive substance. Specific examples of the binder resin include acrylic resins, epoxy resins, oxetane resins, polyurethane resins, polyimide resins, melamine resins, silicone resins, vinyl acetate resins, polyvinyl pyrrolidone, polyester resins, polysaccharides, and derivatives thereof. One of these can be used individually, or two or more can be used in combination.

The thickener may be a compound capable of increasing the viscosity of the solution containing a conductive substance, and specific examples thereof include an alkaline thickener and a urethane thickener. One of these can be used individually, or two or more can be used in combination.

The thickness of the conductive layer is preferably 100 nm or more and 2 $\mu$m or less, and more preferably 200 nm or more and 1 μm or less. When the thickness falls within the above-described numerical range, good conductivity is easily obtained, and a transmittance of visible light is easily increased. Thus, the thickness of the conductive layer is preferably reduced for obtaining a conductive piezoelectric film having better transparency. However, as described above, since the piezoelectric film has lower surface smoothness than that of a film made of PET or the like, it is considered that a small thickness of the conductive layer increases influence of variation in film thickness, leading to variation in transparency or the like. That is, when the thickness falls within the above-described numerical range, the variation in transparency is likely to occur, and the effects of the present invention are likely to be exhibited.

In the case of a conductive layer containing a metal nanowire, measurement of the thickness tends to be difficult because the metal nanowire is sparsely dispersed. In such a case, the thickness of a coating film composed of another component such as a thickener or a binder resin is defined as the thickness of the conductive layer.

Transparent Coating Layer

The conductive piezoelectric film according to an embodiment of the present invention may include a transparent coating layer.

The conductive piezoelectric film 2 includes, as the pair of transparent coating layers, the first transparent coating layer 21 on a surface of the piezoelectric film 11 on the conductive layer 31 side, and the second transparent coating layer 22 on a surface of the piezoelectric film 11 opposite to the conductive layer 31 side. That is, the conductive piezoelectric film 2 has a laminate structure in which the second transparent coating layer 22, the piezoelectric film 11, the first transparent coating layer 21, and the conductive layer 31 are laminated in this order. The thicknesses, structures, and compositions of the first transparent coating layer 21 and the second transparent coating layer 22 may be the same or different. In addition, it is not always necessary to provide both the first transparent coating layer 21 and the second transparent coating layer 22, and only one of either of them may be provided.

Examples of the transparent coating layer include a hard coat layer, an undercoat layer, and an overcoat layer. The transparent coating layer may be a single layer of these or a plurality of layers in combination.

The hard coat layer or the undercoat layer not only protects the surface of the piezoelectric film from scratches and stains, but also fills scratches on the surfaces of the piezoelectric film, resulting in improved transparency (reduced haze). In addition, due to the hard coat layer or the undercoat layer being provided between the conductive layer and the piezoelectric film, the water contact angle of the surface to be applied with the solution containing a conductive substance can be set to 70° or less, and the standard deviation of the total light transmittance can be reduced.

The overcoat layer can suppress oxidation of the metal nanowire by water, air, or light.

The transparent coating layer contains, for example, a resin-cured product obtained by curing a resin composition. The resin composition preferably contains at least one selected from thermosetting resin compositions, ultraviolet-curable resin compositions, and electron beam-curable resin compositions. The resin composition may contain at least one selected from (meth)acrylic ester resins, urethane resins, epoxy-based resins, phenoxy-based resins, and melamine-based resins.

The resin composition is, for example, a composition containing a curable compound having an energy beam-reactive group, such as a (meth)acryloyl group or a vinyl group. The wording "(meth)acryloyl group" means including at least one of an acryloyl group or a methacryloyl group. The curable compound preferably contains a polyfunctional monomer or oligomer containing two or more and preferably three or more energy beam-reactive functional groups per molecule.

Using an energy beam-curable resin composition enables the resin composition to be cured by irradiation with an energy beam, such as ultraviolet light. Thus, using such a resin composition is preferred also from the viewpoint of the manufacturing process.

The curable compound preferably contains an acrylic monomer. Examples of the acrylic monomer include urethane-modified acrylates and epoxy-modified acrylates.

The resin composition preferably contains fine particles (organic fine particles and/or inorganic fine particles) from the viewpoints of increasing the strength of the coating film, increasing the adhesiveness with the conductive layer, and the like. Examples of the organic fine particle include organic silicon fine particles, cross-linked acrylic fine particles, and cross-linked polystyrene fine particles. Examples of the inorganic fine particle include silica particles, calcium carbonate particles, aluminum oxide fine particles, zirconium oxide fine particles, titanium oxide fine particles, and iron oxide fine particles. One of these can be used individually, or two or more can be used in combination.

Too thin a transparent coating layer may make it difficult to sufficiently cover fine surface unevennesses of the piezoelectric film and may fail to provide a sufficient effect of reducing the haze of the piezoelectric film. Too thick a transparent coating layer may result in insufficient piezoelectricity of the conductive piezoelectric film. The thickness of the transparent coating layer is preferably 0.20 μm or more and 3.5 μm or less, more preferably 0.35 μm or more and 2.5 μm or less, and still more preferably 0.50 μm or more and 1.5 μm or less. When the thickness of the transparent coating layer falls within the above-described range, the conductive piezoelectric film can achieve both sufficient piezoelectricity and transparency suited to its application.

Suitable embodiments of the present invention have been described above, but the present invention is not limited to the embodiments described above. For example, the conductive piezoelectric film 2 described above includes a pair of transparent coating layers, but may include only either one of the first transparent coating layer 21 and the second transparent coating layer 22. From the viewpoint of enhancing durability of the conductive layer 31, the conductive piezoelectric films 1 and 2 may include a transparent coating layer as an overcoat layer on the surface of the conductive layer 31 opposite to the piezoelectric film 11. Further, the conductive piezoelectric films 1 and 2 may be provided with an arbitrary layer at an arbitrary position, in addition to the layers described above, as long as the function thereof is not significantly impaired.

Application of Conductive Piezoelectric Film

The conductive piezoelectric film according to an embodiment of the present invention is suitably used in devices such as a piezoelectric panel including a touch panel of an electrostatic capacitance type, a resistive film type, or the like, a pressure sensor, an actuator for a haptic device, a piezoelectric vibration power generator, and a planar speaker. The piezoelectric panel further includes a common display panel unit, such as an LCD, under the conductive piezoelectric film. The above-described devices are suitably used in mobile phones, smartphones, personal digital assistants, tablet PCs, notebook personal computers, ATMs, FA equipment, OA equipment, medical devices, car navigation systems, and the like.

Method for Producing Conductive Piezoelectric Film

The conductive piezoelectric film according to an embodiment of the present invention can be produced by a method including a step of forming a conductive layer having a total light transmittance of 80% or more by applying a solution containing a conductive substance to a surface of a piezoelectric film on which a protective film is laminated, the surface being opposite to the protective film.

The piezoelectric film used can be a piezoelectric film as described in the "Piezoelectric Film". When a piezoelectric film containing a fluorine-based resin is used, the piezoelectric film can be produced by the following method.

When a piezoelectric film containing a fluorine-based resin is produced, the piezoelectric film can be obtained through a step of polarization treatment of a film containing a fluorine-based resin. The film containing a fluorine-based resin may be a stretched film or an unstretched film. In the present embodiment, the film containing a fluorine-based resin is preferably stretched and then subjected to a polarization treatment, from the viewpoint of exhibiting a high piezoelectric effect.

The film containing a fluorine-based resin can be produced by an arbitrary method such as a melt extrusion method, a hot press method, or a solution casting method. In particular, from the viewpoint of easily obtaining a piezoelectric film having a predetermined thickness or larger, the film containing a fluorine-based resin is preferably produced by a melt extrusion method. In the melt extrusion method, a film can be obtained by heating and melting the fluorine-based resin and an arbitrary additive in a cylinder of an extruder, and then extruding the resultant melt from a die.

The obtained film has a structure in which $\alpha$-type crystals (its main chain has a helical structure) and $\beta$-type crystals (its main chain has a planar zigzag structure) are mixed. The $\beta$-type crystal has a large polarization structure. Stretching of the film can convert the $\alpha$-type crystals into the $\beta$-type crystals. In the stretching, a stretching ratio is preferably adjusted, as necessary, for crystallizing the fluorine-based resin into $\beta$-type crystals. The stretching direction may be the TD direction or the MD direction, and is more preferably the MD direction.

The stretching method is not particularly limited, and the stretching can be performed by a known stretching method such as a tenter method or a drum method.

The stretching ratio may be, for example, 3.0 times or more and 6.0 times or less. When the stretching ratio is 3.0 times or more, it is easy to adjust the thickness and polarizability of the film to more appropriate ranges. When the stretching ratio is 3.0 times or more, dislocation of the $\beta$-type crystals becomes more sufficient, and not only higher piezoelectricity is likely to be exhibited but also transparency can be further enhanced. When the stretching ratio is 6.0 times or less, breakage due to stretching can be further suppressed.

The obtained stretched film is preferably subjected to a polarization treatment. The polarization treatment can be performed by, for example, applying a DC voltage between a ground electrode and a needle-shaped electrode. The voltage may be adjusted in accordance with the thicknesses of the stretched film, and can be, for example, from 1 kV to 50 kV.

As described above, the piezoelectric film can be obtained by subjecting the stretched film to a polarization treatment, in the present embodiment.

The piezoelectric film on which the protective film is laminated is obtained by, for example, a method of bonding the protective film and the piezoelectric film using a laminator, a multicoater, or the like.

The modulus of elasticity of the protective film is preferably 1.0 GPa or more, more preferably 2.0 GPa or more, and still more preferably 2.5 GPa or more. By bonding a protective film having a modulus of elasticity of 1.0 GPa or more to the piezoelectric film, the surfaces of the piezoelectric film can be suitably planarized. According to such a configuration, the variation in transparency of the conductive piezoelectric film can be further suppressed. In the present specification, the modulus of elasticity of the protective film means a tensile modulus of elasticity of a base material, and is a value as measured in conformity with JIS K 7127:1999.

The base material of the protective film is not particularly limited as long as its modulus of elasticity satisfies the above-described range, and examples thereof include polyesters such as polyethylene terephthalate (PET) and polybutylene terephthalate; polyolefins such as polyethylene (PE) and polypropylene (PP); halogen-containing polymers such as polyvinyl chloride (PVC) and polyvinylidene fluoride (PVDF); acrylic polymers such as polymethyl methacrylate; and styrene-based polymers such as polystyrene and styrene-methyl methacrylate copolymers. Among these, PET and PP are preferred, and PET is more preferred from the viewpoint of its higher modulus of elasticity. In addition, these films may be non-stretched films or more preferably biaxially stretched films.

A thickness of the base material of the protective film is preferably 30 μm or more and more preferably 50 μm or more. In addition, the thickness of the base material is preferably 300 μm or less and more preferably 150 μm or less. When the thickness falls within the above-described range, the smoothness of the piezoelectric film is further improved, and the variation in transparency of the conductive piezoelectric film can be further suppressed.

The conductive substance is not particularly limited, but is preferably a conductive substance (transparent conductive substance) that forms a transparent (for example, the total light transmittance is 80% or more) conductive layer, and examples thereof include the above-described silver nanowires, conductive polymers, carbon nanotubes, and graphene. It preferably does not contain carbon black, graphite or the like which forms an opaque conductive layer.

The solvent used in the solution containing a conductive substance is not particularly limited as long as the conductive substance can be dispersed therein, and may be appropriately selected depending on the desired viscosity, drying rate, and the like. For example, in the case of silver nanowires, water or an alcohol-based solvent such as ethanol, methanol, or 1-propanol can be used. In the case of a conductive polymer, an ether-based solvent such as propylene glycol dimethyl ether, a nitrogen atom-containing solvent such as N-methylpyrrolidone, or a sulfur atom-containing solvent such as dimethyl sulfoxide can be used in addition to water or an alcohol solvent. One of these can be used individually, or two or more can be used in combination. The solution may also contain any other component as described above in addition to the conductive substance.

A content of the conductive substance in 100 mass% of the solution is not particularly limited and can be appropriately set in consideration of coating properties, drying properties, and the like. For example, the content is 0.01 mass% or more and 5 mass%.

The method of applying the solution containing a conductive substance is not particularly limited, and the application can be performed by a known method. Examples of the application method include an extrusion nozzle method, a blade method, a knife method, a bar-coating method, a kiss-coating method, a kiss reverse method, a gravure roll method, a dip method, a reverse roll method, a direct roll method, a curtain method, and a squeeze method. Any appropriate drying method (for example, natural drying, air-blowing drying, or heat-drying) can be employed as the drying method after application. For example, in the case of heat-drying, the drying temperature is, for example, from 50°C to 130°C, and the drying time is, for example, from 0.5 to 10 minutes, for the purpose of preventing the resistance of the piezoelectric film from being deteriorated and the color of the film from being impaired.

There is a possibility that the variation in transparency may occur because the piezoelectric film has low wettability with respect to the solution containing a conductive substance and the solution is repelled and applied unevenly. Therefore, the water contact angle of the surface to be applied with the solution is preferably 70° or less. When the water contact angle is 70° or less, the adhesiveness of the conductive layer is likely to be good. In the present specification, the water contact angle is a value obtained by dropwise adding a pure water droplet (2.0 μL) on a surface using a contact angle meter FACE CA-V (available from Kyowa Interface Science Co., Ltd.), measuring a contact angle 10 times 3 seconds after the dropwise addition, and arithmetically averaging the measured contact angles.

Examples of a technique for adjusting the water contact angle of the surface to be applied with the solution to 70° or less include a technique of subjecting the surface of the piezoelectric film to be applied with the solution to a surface modification treatment such as a corona treatment, a plasma treatment, a flame treatment, or an ultraviolet irradiation treatment, and a technique of forming a transparent coating layer on the surface of the piezoelectric film to be applied with the solution.

The transparent coating layer can be prepared by applying a solution or dispersion of the resin composition onto a surface of the piezoelectric film, drying the solution or dispersion liquid, and curing the resin composition. The application at this time can be performed by a method similar to the method for applying the solution containing a conductive substance described above.

The protective film may be peeled off from the piezoelectric film after the conductive layer is formed by the above-described processes. The peeling method is not particularly limited. After the protective film is peeled off, a transparent coating layer may be formed on the surface of the piezoelectric film on the peeled side or the surface of the conductive layer opposite to the piezoelectric film.

Examples

The present invention will be further described with reference to examples and comparative examples below, but the present invention is not limited to these examples.

The properties of the conductive piezoelectric film according to an embodiment of the present invention were measured by the following methods, and the results are shown in Table 1.

Evaluation of Physical Properties

Surface Waviness

With respect to the conductive piezoelectric films of Examples and Comparative Examples, the surface waviness Wa ($\mu$m) on the conductive layer side was measured using a 3D shape measuring machine ("VR-5000" available from KEYENCE CORPORATION) and a multifile analysis application ("VR-H3CA" available from KEYENCE CORPORATION). A test piece cut to a size of 50 mm $\times$ 50 mm was placed on a stage in a state where the surface of the conductive layer was on the front side. Four corners of the test piece were fixed with a tape without application of tension. As preprocessing, a reference plane was set by designating a plurality of points, surface shape correction was performed at a correction intensity of 5 for waviness removal, and smoothing was performed with a simple average of 3 $\times$ 3. The measurement was performed by photographing the test piece with a low magnification camera. The measurement was performed under the following conditions: the mode was a multi-line roughness mode, the number of peripheral lines was 5, the interval was 70 lines apart, the region was a horizontal line (TD direction), and no cutoff was provided. The measurement was carried out three times, and an arithmetic average value was defined as the surface waviness Wa.

Thermal Shrinkage

In a test method in accordance with JIS K 7133, the conductive piezoelectric film was cut into dimensions of 100 mm $\times$ 100 mm, and distances (L0 and T0) between two marked lines before the test, which were marked in the longitudinal direction and the lateral direction on the cut test piece, were measured. The flow direction of the film during formation of the conductive layer was defined as the longitudinal direction, and the direction perpendicular thereto was defined as the lateral direction. Then, the test piece was heated in a hot air drying furnace heated to a predetermined temperature (80°C) for a predetermined time (30 minutes), conditioned at room temperature for at least 30 minutes, remeasured for distances (L and T) between the marked lines in the longitudinal direction and the lateral direction, and calculated for changes ($\Delta$L and $\Delta$T) in distances between the marked lines of the test piece in the longitudinal direction and the lateral direction by the following equations (1) and (2):

$$\Delta L = [(L-L0)/L0] \times 100 \ (\%) \ (1)$$

$$\Delta T = [(T-T0)/T0] \times 100 \ (\%) \ (2)$$

The change ($\Delta$L) in distance between the marked lines in the longitudinal direction was defined as thermal shrinkage in the longitudinal direction (MD) of the film, and the change ($\Delta$T) in distance between the marked lines in the lateral direction was defined as thermal shrinkage in the lateral direction of the film. In all Examples and Comparative Examples, the absolute value of the thermal shrinkage in the lateral direction was smaller than the absolute value of the thermal shrinkage in the longitudinal direction, and thus the absolute value of the thermal shrinkage in the longitudinal direction was maximum.

Adhesiveness

The adhesiveness of each conductive piezoelectric film was evaluated using a cross-cut method. In the conductive layer of each conductive piezoelectric film, 11 vertical lines and 11 horizontal lines at 1-mm intervals were drawn with a utility knife to prepare 100 squares. Then, a tape (Cellotape (trade name) available from Nichiban Co., Ltd., adhesive strength 4.01 N/10 mm) was applied to the conductive layer and peeled off, and a proportion of the conductive layer that peeled off from the conductive piezoelectric film was evaluated according to the following evaluation criteria based on ASTM D3359.

0B: 65% or more peeled off
1B: 35% or more and less than 65% peeled off
2B: 15% or more and less than 35% peeled off
3B: 5% or more and less than 15% peeled off
4B: less than 5% peeled off
5B: no peeling off

Sheet Resistance

The resistance ($\Omega$/sq) of each of the conductive piezoelectric films of Examples and Comparative Examples was measured in conformity with JIS K7194 using a resistivity meter ("Loresta-GP MCP-T610", available from Nittoseiko Analytech Co., Ltd.). The resistance was measured three times, and the arithmetic average value of the three results was determined as a representative value.

Evaluation of Optical Characteristics

Total Light Transmittance

The total light transmittance (%) of each of the conductive piezoelectric films of Examples and Comparative Examples was measured in conformity with JIS K 7361-1 using a haze meter ("NDH7000SP II", available from Nippon Denshoku Industries Co., Ltd.). Measurement was performed at 15 points on the test piece of 10 cm $\times$ 15 cm, and the arithmetic average value of the results was determined as a representative value.
The standard deviation of the total light transmittance was calculated based on the following equation:

[Math. 1]

$$S = \sqrt{\frac{1}{n}\sum_{i=1}^{n}(x_i - x_{ave})^2}$$

where in the equation, s represents a standard deviation, n represents a number of measurement points, $x_i$ represents a total light transmittance at each measurement point, and $x_{ave}$ represents an average value of the total light transmittances at the respective measurement points.

Haze Value

The haze value (%) of each of the conductive piezoelectric films of Examples and Comparative Examples was measured in conformity with JIS K 7136 using a haze meter ("NDH7000SP II", available from Nippon Denshoku Industries Co., Ltd.). Measurement was performed at 15 points on the test piece of 10 cm $\times$ 15 cm, and the arithmetic average value of the results was determined as a representative value.

Example 1

A resin film (120 $\mu$m in thickness) formed from polyvinylidene fluoride (available from Kureha Corporation) with an inherent viscosity of 1.1 dL/g was uniaxially stretched at a stretching ratio of 4.2 times. After stretching, the polarization treatment was performed by applying a DC voltage between a ground electrode and a needle-shaped electrode while the DC voltage was increased from 0 kV to 12.0 kV. The film after the polarization treatment was further heat-treated at 130°C for 1 minute, and a piezoelectric film with a thickness of 40 $\mu$m was obtained. The piezoelectric film had a $d_{33}$ of 14.0 pC/N and a water contact angle of 84°.
Next, a protective film (base material: polyethylene terephthalate, modulus of elasticity: 3800 MPa, thickness: 125 $\mu$m) and the piezoelectric film were bonded to each other using a multicoater, and then wound into a roll to obtain a laminate film. For the multicoater, the line speed was set to 5 m/min, and the laminate roll contact pressure was set to approximately 0.3 N. Further, the surface of the laminate film on the piezoelectric film side was subjected to a corona treatment to obtain a laminate film in which the surface on the piezoelectric film side had a water contact angle of 70°.
With reference to the method described in Chem. Mater., 2002, 14, 4736 to 4745, silver nanowires having an average diameter of 30 nm and an average length of 9.5 μm were prepared, separated by filtration using a filter, subjected to a water washing treatment, and then redispersed in ethanol to prepare a silver nanowire dispersion liquid (silver nanowire content: 0.2 mass%). Further, a silver nanowire ink containing 63 mass% of the silver nanowire dispersion liquid and 37 mass% of a dispersion medium (ultrapure water) containing a thickener and a surfactant was prepared.

The prepared silver nanowire ink was applied to the surface of the laminate film on the piezoelectric film side with a bar coater, and the wet thickness of the ink was 18 μm. The ink was dried at 80°C for 4 minutes.

Subsequently, the protective film was peeled off from the piezoelectric film, and then an amorphous silica-containing ultraviolet-curable resin composition composed of an acrylic resin was applied to the surface of the piezoelectric film from which the protective film was peeled off, and dried at 80°C for 2 minutes. The dried coating film was irradiated with UV at an integrated light amount of 400 mJ/cm$^2$ using a UV irradiation device CSOT-40 (available from GS Yuasa Corporation) to obtain a conductive piezoelectric film having a 200 nm thick conductive layer on one surface of the piezoelectric film and a 0.7 μm-thick transparent coating layer on the other surface.

Example 2

A conductive piezoelectric film having a 160 nm thick conductive layer on one surface of the piezoelectric film and a 0.7 μm-thick transparent coating layer on the other surface was obtained in the same manner as in Example 1 except that the wet thickness of the silver nanowire ink was changed to 11 μm.

Comparative Example 1

A piezoelectric film with a thickness of 40 μm was obtained in the same manner as in Example 1.

The prepared silver nanowire dispersion liquid was applied to one surface of the piezoelectric film with a bar coater, and the wet thickness of the dispersion liquid was 25 μm. The dispersion liquid was dried at 80°C for 4 minutes to obtain a conductive piezoelectric film.

Comparative Example 2

A conductive piezoelectric film was obtained in the same manner as in Comparative Example 1 except that the wet thickness of the silver nanowire dispersion liquid was changed to 18 μm.

Example 3

An amorphous silica-containing ultraviolet-curable resin composition composed of an acrylic resin was applied to one surface of the piezoelectric film obtained in the same manner as in Example 1, and dried at 80°C for 2 minutes. The dried coating film was irradiated with UV at an integrated light amount of 400 mJ/cm$^2$ using the UV irradiation device CSOT-40 (available from GS Yuasa Corporation), and a transparent coating layer a was formed. Next, a protective film was bonded to a surface of the transparent coating layer a in the same manner as in Example 1 to obtain a laminate film.

An amorphous silica-containing ultraviolet-curable resin composition composed of an acrylic resin was applied to the surface of the laminate film on the piezoelectric film side, and dried at 80°C for 2 minutes. The dried coating film was irradiated with UV at an integrated light amount of 400 mJ/cm$^2$ using the UV irradiation device CSOT-40 (available from GS Yuasa Corporation), and a transparent coating layer b was formed.

Next, a conductive polymer (PEDOT:PSS) dispersion liquid having a solid content concentration of 2.5 mass% was applied to a surface of the transparent coating layer b with a bar coater, and a wet thickness of the dispersion liquid was 25 μm. The dispersion liquid was dried at 80°C for 4 minutes to obtain a conductive piezoelectric film having a 0.7 μm-thick transparent coating layer on both surfaces of the piezoelectric film and a 0.7 μm-thick conductive layer on one surface.

Example 4

A laminate film having a protective film and a piezoelectric film which were bonded to each other was obtained in the same manner as in Example 1. An amorphous silica-containing ultraviolet-curable resin composition composed of an acrylic resin was applied to the surface of the laminate film on the piezoelectric film side, and dried at 80°C for 2 minutes. The dried coating film was irradiated with UV at an integrated light amount of 400 mJ/cm$^2$ using the UV irradiation device CSOT-40 (available from GS Yuasa Corporation), and a transparent coating layer was formed. Next, a conductive polymer (PEDOT:PSS) dispersion liquid having a solid content concentration of 2.5 mass% was applied to a surface of the transparent coating layer with a bar coater, and a wet thickness of the dispersion liquid was 10 μm. The dispersion liquid was dried at 80°C for 4 minutes to obtain a conductive piezoelectric film having a 0.7 μm-thick transparent coating layer and a 0.3 μm-thick conductive layer on one surface of the piezoelectric film.

Comparative Example 3

A piezoelectric film with a thickness of 40 $\mu$m was obtained in the same manner as in Example 1.

A conductive polymer (PEDOT:PSS) dispersion liquid having a solid content concentration of 2.5 % was applied to one surface of the piezoelectric film with a bar coater, and the wet thickness of the dispersion liquid was 52 $\mu$m. The dispersion liquid was dried at 80°C for 4 minutes to obtain a conductive piezoelectric film. The sheet resistance was difficult to measure.

[Table 1]

| | | Total light transmittance | Standard deviation | Haze value | Surface waviness | Thermal Shrinkage Rate | | Adhesiveness | Sheet resistance |
|---|---|---|---|---|---|---|---|---|---|
| | | % | % | % | [μm] | MD [%] | TD [%] | [-] | [Ω/sq] |
| Silver nanowire | Example 1 | 90.2 | 0.7 | 1.7 | 24.2 | -0.3 | 0.1 | 5B | 50 |
| | Example 2 | 90.8 | 0.5 | 1.8 | 22.6 | -0.3 | 0.1 | 5B | 130 |
| | Comparative Example 1 | 85.8 | 2.2 | 4.1 | 35.9 | -0.3 | 0.1 | 5B | - |
| | Comparative Example 2 | 88.1 | 2.5 | 2.9 | 38.2 | -0.3 | 0.1 | 5B | - |
| Conductive polymer | Example 3 | 87.4 | 0.3 | 0.9 | 8.7 | -0.3 | 0.1 | 5B | 231 |
| | Example 4 | 89.4 | 0.1 | 0.9 | 17.1 | -0.3 | 0.1 | 5B | 355 |
| | Comparative Example 3 | 74.2 | 4.5 | 2.9 | 40.1 | -0.3 | 0.1 | 5B | - |

As shown in Table 1, the standard deviations of the total light transmittance were low in Examples. Therefore, it was confirmed that a conductive piezoelectric film having a suppressed variation in transparency can be obtained according to the present invention.

**REFERENCE SIGNS LIST**

1, 2: Conductive piezoelectric film

11: Piezoelectric film

21: First transparent coating layer

22: Second transparent coating layer

31: Conductive layer

**Claims**

1.  A conductive piezoelectric film comprising: a piezoelectric film; and a conductive layer laminated on one surface of the piezoelectric film,

    wherein a total light transmittance is 80% or more,
    a standard deviation of the total light transmittance is 1.4% or less, and
    the conductive layer comprises at least one selected from the group consisting of a metal nanowire, a conductive polymer, a carbon nanotube, and graphene.

2.  The conductive piezoelectric film according to claim 1, wherein a surface waviness Wa of the piezoelectric film at an interface with the conductive layer is 30 $\mu$m or less.

3.  The conductive piezoelectric film according to claim 1 or 2, wherein an absolute value of a thermal shrinkage when the film is heat treated at 80°C for 30 minutes is at most less than 1.0%.

4.  The conductive piezoelectric film according to claim 1 or 2, wherein an adhesiveness of the conductive layer as evaluated based on ASTM D3359 is 4B or more.

5.  The conductive piezoelectric film according to claim 1 or 2, wherein the metal nanowire is a silver nanowire.

6.  The conductive piezoelectric film according to claim 1 or 2, wherein the piezoelectric film comprises a fluorine-based resin.

7.  A device comprising the conductive piezoelectric film described in claim 1 or 2.

8.  A method for producing a conductive piezoelectric film, the method comprising a step of forming a conductive layer having a total light transmittance of 80% or more by applying a solution comprising a conductive substance comprising at least one selected from the group consisting of a metal nanowire, a conductive polymer, a carbon nanotube, and graphene to a surface of a piezoelectric film on which a protective film is laminated, the surface being opposite to the protective film.

9.  The method for producing a conductive piezoelectric film according to claim 8, wherein a water contact angle of the surface to be applied with the solution in the step is 70° or less.

10. The method for producing a conductive piezoelectric film according to claim 8 or 9, wherein a modulus of elasticity of the protective film is 1.0 GPa or more.

FIG. 1

FIG. 2

## INTERNATIONAL SEARCH REPORT

International application No.

**PCT/JP2023/018367**

### A. CLASSIFICATION OF SUBJECT MATTER

***H10N 30/87***(2023.01)i; ***G06F 3/041***(2006.01)i; ***G06F 3/047***(2006.01)i; ***H01B 5/14***(2006.01)i; ***H10N 30/045***(2023.01)i; ***H10N 30/06***(2023.01)i; ***H10N 30/20***(2023.01)i; ***H10N 30/30***(2023.01)i; ***H10N 30/857***(2023.01)i
FI: H10N30/87; H01B5/14 Z; H10N30/06; H10N30/857; H10N30/045; H10N30/30; H10N30/20; G06F3/047 C; G06F3/041 490

According to International Patent Classification (IPC) or to both national classification and IPC

### B. FIELDS SEARCHED

Minimum documentation searched (classification system followed by classification symbols)

H10N30/87; G06F3/041; G06F3/047; H01B5/14; H10N30/045; H10N30/06; H10N30/20; H10N30/30; H10N30/857

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | WO 2022/091829 A1 (KUREHA CORPORATION) 05 May 2022 (2022-05-05) paragraphs [0012]-[0112] | 1-10 |
| Y | JP 2013-146972 A (TORAY IND INC) 01 August 2013 (2013-08-01) paragraphs [0010], [0033], [0042], [0055], [0060], table 1 | 1-7, 9-10 |
| Y | WO 2016/076071 A1 (MITSUI CHEMICALS, INC.) 19 May 2016 (2016-05-19) paragraphs [0014]-[0018], [0051], [0124], table 2 | 2-7 |
| Y | JP 2021-174834 A (DAIKIN IND LTD) 01 November 2021 (2021-11-01) paragraphs [0011]-[0012], [0051]-[0053] | 3 |
| Y | WO 2021/200790 A1 (KUREHA CORPORATION) 07 October 2021 (2021-10-07) paragraphs [0026], [0030], [0053] | 8-10 |
| Y | WO 2017/155006 A1 (MITSUI CHEMICALS, INC.) 14 September 2017 (2017-09-14) table 2 | 10 |

☐ Further documents are listed in the continuation of Box C.　　☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **18 July 2023** | **25 July 2023** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (January 2015)

INTERNATIONAL SEARCH REPORT
Information on patent family members

International application No.

**PCT/JP2023/018367**

| Patent document cited in search report | | | Publication date (day/month/year) | Patent family member(s) | | | Publication date (day/month/year) |
|---|---|---|---|---|---|---|---|
| WO | 2022/091829 | A1 | 05 May 2022 | TW | 202217862 | A | |
| JP | 2013-146972 | A | 01 August 2013 | (Family: none) | | | |
| WO | 2016/076071 | A1 | 19 May 2016 | US | 2017/0317268 | A1 | |
| | | | | paragraphs [0038]-[0046], [0118]-[0121], [0297]-[0299], table 2 | | | |
| | | | | EP | 3220432 | A1 | |
| | | | | KR | 10-2017-0069255 | A | |
| | | | | CN | 107078208 | A | |
| | | | | TW | 201617405 | A | |
| JP | 2021-174834 | A | 01 November 2021 | US | 2023/0069063 | A1 | |
| | | | | paragraphs [0020]-[0021], [0085]-[0091] | | | |
| | | | | EP | 4141051 | A1 | |
| | | | | WO | 2021/215284 | A1 | |
| | | | | TW | 202202533 | A | |
| | | | | KR | 10-2022-0158003 | A | |
| | | | | CN | 115428177 | A | |
| WO | 2021/200790 | A1 | 07 October 2021 | EP | 4129669 | A1 | |
| | | | | paragraphs [0026], [0030], [0053] | | | |
| | | | | KR | 10-2022-0140840 | A | |
| | | | | CN | 115362059 | A | |
| | | | | TW | 202138191 | A | |
| WO | 2017/155006 | A1 | 14 September 2017 | US | 2019/0088850 | A1 | |
| | | | | table 2 | | | |
| | | | | EP | 3418049 | A1 | |
| | | | | KR | 10-2018-0105226 | A | |
| | | | | CN | 108698371 | A | |
| | | | | TW | 201805156 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H05324203 A

**Non-patent literature cited in the description**

- *Chem. Mater.*, 2002, vol. 14, 4736-4745

- *J. Am. Chem. Soc.*, 2007, vol. 129, 1733-1742